(19) Europäisches Patentamt
European Patent Office
Office européen des brevets

(11) **EP 2 494 688 B1**

(12) **EUROPÄISCHE PATENTSCHRIFT**

(45) Veröffentlichungstag und Bekanntmachung des Hinweises auf die Patenterteilung:
**25.07.2018 Patentblatt 2018/30**

(51) Int Cl.:
*H02M 5/297* *(2006.01)*   *H02M 1/00* *(2006.01)*
*H02M 7/483* *(2007.01)*

(21) Anmeldenummer: **10776701.4**

(22) Anmeldetag: **12.11.2010**

(86) Internationale Anmeldenummer:
**PCT/EP2010/067378**

(87) Internationale Veröffentlichungsnummer:
**WO 2011/067090 (09.06.2011 Gazette 2011/23)**

(54) **VERFAHREN ZUM BETRIEB EINER UMRICHTERSCHALTUNG SOWIE VORRICHTUNG ZUR DURCHFÜHRUNG DES VERFAHRENS**

METHOD FOR OPERATING AN INVERTER CIRCUIT AND DEVICE FOR CARRYING OUT SAID METHOD

PROCÉDÉ POUR FAIRE FONCTIONNER UN CIRCUIT INVERSEUR ET DISPOSITIF POUR METTRE EN OELIGUVRE LE PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.12.2009 EP 09177578**

(43) Veröffentlichungstag der Anmeldung:
**05.09.2012 Patentblatt 2012/36**

(73) Patentinhaber: **ABB Schweiz AG**
**5400 Baden (CH)**

(72) Erfinder: **KORN, Arthur**
**CH-5400 Baden (CH)**

(74) Vertreter: **ABB Patent Attorneys**
**C/o ABB Schweiz AG**
**Intellectual Property (CH-LI/IP)**
**Brown Boveri Strasse 6**
**5400 Baden (CH)**

(56) Entgegenhaltungen:
WO-A1-2008/067784     WO-A2-03/090331
WO-A2-2007/033852     DE-A1-102005 040 543
US-A1- 2004 022 081

- **ANTONIOS ANTONOPOULOS ET AL: "On dynamics and voltage control of the Modular Multilevel Converter", POWER ELECTRONICS AND APPLICATIONS, 2009. EPE '09. 13TH EUROPEAN CONFERENCE ON, IEEE, PISCATAWAY, NJ, USA, 8. September 2009 (2009-09-08), Seiten 1-10, XP031541295, ISBN: 978-1-4244-4432-8**
- **COLIN OATES: "A methodology for developing 'Chainlink' converters", 13TH EUROPEAN CONFERENCE ON POWER ELECTRONICS AND APPLICATIONS, 2009 : EPE '09 ; 8 - 10 SEPT. 2009, BARCELONA, SPAIN, IEEE, PISCATAWAY, NJ, USA, 8 September 2009 (2009-09-08), pages 1-10, XP031541239, ISBN: 978-1-4244-4432-8**

**Beschreibung**

**Technisches Gebiet**

Die Erfindung bezieht sich auf das Gebiet der Leistungselektronik. Sie geht aus von einem Verfahren zum Betrieb einer Umrichterschaltung sowie Vorrichtung zur Durchführung des Verfahrens gemäss dem Oberbegriff der unabhängigen Ansprüche.

**Stand der Technik**

Direktumrichter, insbesondere Matrixumrichter, hatten in der Vergangenheit eher akademische Bedeutung. Heute jedoch gewinnen Direktumrichter vor allem für industrielle Anwendungen an Bedeutung, da mittels eines Direktumrichters ohne aufwendigen Gleichspannungszwischenkreis oder Gleichstromzwischenkreis eine Eingangsspannung bzw. ein Eingangsstrom einer ersten Amplitude und einer ersten Frequenz direkt in eine Ausgangsspannung bzw. in einen Ausgangsstrom einer zweiten Amplitude und einer zweiten Frequenz umgewandelt werden kann. Ein solcher Direktumrichter ist beispielsweise in der US 6,900,998 B2 angegeben. Darin weist der Direktumrichter n=3 Eingangsphasenanschlüsse und p=3 Ausgangsphasenanschlüsse, d.h. der Direktumrichter der US 6,900,998 B2 ist eingangseitig und ausgangsseitig dreiphasig ausgebildet. Der Direktumrichter der US 6,900,998 B2 umfasst weiterhin neun Phasenbausteine mit jeweils einer zweipoligen Schaltzellen zum Schalten einer positiven und einer negativen Spannung zwischen den Polen, wobei jeder Ausgangsphasenanschluss mit jedem Eingangsphasenanschluss jeweils unmittelbar über eine Schaltzelle seriell verbunden ist. Eine solche Schaltzelle weist ansteuerbare bidirektionale Leistungshalbleiterschalter mit gesteuerter unidirektionaler Stromführungsrichtung und einen kapazitiven Energiespeicher auf. Die Phasenbausteine des Direktumrichters nach der US 6,900,998 B2 enthalten nur Schaltzellen und keine Induktivitäten. Die Spannung an jedem Zweig, d.h. an jeder zweipoligen Schaltzelle kann somit nicht derart eingestellt werden, dass ein kontinuierlicher Stromfluss von einem Eingangsphasenanschluss zu einem Ausgangsphasenanschluss erzielt werden kann, wodurch keine aktive Stromeinstellung durch den jeweiligen Zweig und durch den jeweiligen Phasenbaustein möglich ist. Die Ströme der Ausgangsphasenanschlüsse der Phasenbausteine werden diskret auf die einzelnen Phasenbausteine geschaltet, d.h. die Ströme der einzelnen Phasenbausteine beschreiben diskontinuierliche Funktionen die abschnittsweise zwischen Null und dem momentanen Wert des Stromes in dem zugehörigen Ausgangsphasenanschluss springen. Das Zu- und Abschalten der Ströme an den Ausgangsphasenanschlüssen der Phasenbausteine benötigt einen komplexen Steueralgorithmus, der über aufwändige Tabellen gelöst ist. Dabei ist zu beachten, dass einzelne Phasen niemals zu einer Spannungsmasche kurzgeschlossen werden dürfen, da die Gesamtspannungen zweier Phasenbausteine im Normalfall nicht genau gleich sind. Gleichzeitig darf der Stromfluss in den Anschlüssen niemals unterbrochen werden, d.h. die Phasenbausteine müssen immer genau gleichzeitig geschaltet werden, was einen erheblichen Steuerungsaufwand bedeutet. Zudem führt das Zu- und Abschalten der vollen Ströme zu einem hohen Effektivstrom (RMS Strom) mit entsprechend hohen Verlusten in den Bauelementen und insbesondere in den Leistungshalbleiterschaltern.

Durch verschiedene Ursachen kann die Leistung eines Phasenbausteines und insbesondere auch die Leistung aller Schaltzellen eines Phasenbausteins im Mittel von Null abweichen, falls der Phasenbaustein beispielsweise mehrere Schaltzellen aufweist. Ursache können eine unzureichende Steuerung, transiente Betriebszustände, bestimmte Symmetrien zwischen Schalthandlungen und den Strömen durch die Phasenbausteine oder auch bauliche Unterschiede einzelner Komponenten sein. Wenn die mittlere Spannungsabweichung der kapazitiven Energiespeicher aller Schaltzellen eines Phasenbausteins ungleich Null ist, kann eine erhebliche Abweichung der Spannung über dem Phasenbaustein resultieren, die dann wiederum zu unkontrollierten Kreisströmen durch die Phasenbausteine führen.

Weiterhin ist mit dem Direktumrichter der US 6,900,998 B2 kein oder nur ein sehr eingeschränkter Austausch elektrischer Energie zwischen einzelnen Zweigen möglich. Soll der Direktumrichter aber in der Lage sein, eine grosse elektrische Energiemengen zu übertragen, so sind die Kapazitäten der Schaltzellen der US 6,900,998 B2 entsprechend gross zu Dimensionieren, woraus ein enormer Platzbedarf eines solchen Direktumrichters und erhebliche Kosten resultieren. Systeme, aufgebaut mit derartigen Direktumrichtern werden dadurch ebenfalls einen entsprechend grossen Platzbedarf aufweisen und entsprechend teuer sein.

In der WO 2008/067788 A1 ist ein Verfahren für den Betrieb der Umrichterschaltung nach der WO 2007/023064 A1 angegeben, die den Energiegehalt der Schaltzellen regeln. Das in der WO 2008/067788 A1 beschriebene Verfahren gilt nur für Ausführungen der Umrichterschaltung nach der WO 2007/023064 A1, die drei Phasen eines Systems mit zwei Phasen eines anderen Systems verbinden. In "On Dynamics and Voltage Control of the Modular Multilevel Converter", Power Electronics and Applications, 2009, EPE 2009, 13th European Conference on IEEE, 18.09.2009 ist ein weiteres Verfahren zum Betrieb einer Umrichterschaltung angegeben, bei dem jeder Phasenbaustein mehrere zweipolige seriell zueinander geschaltete Schaltzellen umfasst und jede Schaltzelle ansteuerbare bidirektionale Leistungshalbleiterschalter mit gesteuerter unidirektionaler Stromführungsrichtung und einen kapazitiven Energiespeicher aufweist. Darüber hinaus ist auch in der WO 2008/067784 A1 ein gattungsgemässes Verfahren zum Betrieb einer Umrichterschaltung angegeben.

In Colin Oates, "A methodology for developing 'Chainlink' converters", IEEE 13th European conference on power electronics and applications, 2009, Seiten 1-10 (XP031541239) ist eine Vorrichtung zum Betrieb einer Umrichterschaltung in verketteter Topologie ("Chainlink") gezeigt. Stromquellenschaltungen bzw. -module werden von einer Vektorregelungseinrichtung angesteuert, die verschiedene Spannungs- und Stromwerte als Eingangsgrößen verwendet.

## Darstellung der Erfindung

Aufgabe der Erfindung ist es deshalb, ein Verfahren zum Betrieb einer Umrichterschaltung, insbesondere einen Direktumrichter, anzugeben, mittels welchem Verfahren unerwünschte Kreisströme durch Phasenbausteine der Umrichterschaltung reduziert werden können. Ferner ist es eine Aufgabe der Erfindung, eine Vorrichtung anzugeben, mit der das erfindungsgemässe Verfahren in besonders einfacher Weise durchgeführt werden kann.

Diese Aufgaben werden durch die Merkmale der Ansprüche 1 und 3, bzw. 2 und 4 gelöst. Die Umrichterschaltung, welche insbesondere ein Direktumrichter ist, weist n Eingangsphasenanschlüssen und p Ausgangsphasenanschlüssen auf, wobei $n \geq 2$ und $p \geq 2$ ist. Weiterhin umfasst die Umrichterschaltung n·p zweipoligen Schaltzellen zum Schalten mindestens einer positiven und mindestens einer negativen Spannung zwischen den Polen umfasst, wobei jeder Ausgangsphasenanschluss mit jedem Eingangsphasenanschluss jeweils über eine Schaltzelle seriell verbunden ist. Jede Schaltzelle weist ansteuerbare bidirektionale Leistungshalbleiterschalter mit gesteuerter unidirektionaler Stromführungsrichtung und einen kapazitiven Energiespeicher auf. Verfahrensmässig werden die Leistungshalbleiterschalter der Schaltzellen mittels eines Ansteuersignals angesteuert. Nach der Erfindung ist nun in jede serielle Verbindung mindestens eine Induktivität eingeschaltet, wobei jeweils eine Schaltzelle mit einer Induktivität einen Phasenbaustein bildet, und für jeden Phasenbaustein wird das Ansteuersignal aus einem Referenzsignal bezüglich der Spannung über dem Phasenbaustein und aus einem Spannungssignal über der Induktivität gebildet. Das Spannungssignal über der Induktivität wird ferner aus einem Stromzwischensollwert des Stromes durch den Phasenbaustein gebildet. Dadurch, dass der jeweilige Stromzwischensollwert an dem zugehörigen Phasenbaustein in die Bildung des Spannungssignals über der Induktivität und damit in die Bildung des Ansteuersignals eingeht, kann erreicht werden, dass unerwünschte Kreisströme durch die Phasenbausteine der Umrichterschaltung vorteilhafterweise zu Null geregelt werden können. Zudem kann die Wirkung der für die Regelung benötigten Kreisströme auf die Ströme in den Ausgangsphasenschlüssen mit Vorteil beeinflusst bzw. genau vorgegeben werden. Eine Verteilung der Ströme an den Eingangphasenanschlüssen und an den Ausgangsphasenschlüssen kann durch das erfindungsgemässe Verfahren zudem kontinuierlich verschiedenen Anteilen auf die einzelnen Phasenbausteine erfolgen. Das hier beschriebene Verfahren eignet sich für Umrichterschaltungen mit beliebiger Phasenzahl.

Die erfindungsgemässe Vorrichtung zur Durchführung des Verfahrens zum Betrieb der Umrichterschaltung weist eine der Erzeugung des Ansteuersignals dienenden Ansteuerschaltung für jeden Phasenbaustein auf, welche Ansteuerschaltung mit den Leistungshalbleiterschaltern der Schaltzellen des Phasenbausteins verbunden ist. Bezüglich eines jeden Phasenbausteins ist der Ansteuerschaltung zur Bildung des Ansteuersignals die Summe aus dem Referenzsignal bezüglich der Spannung über dem Phasenbaustein und aus dem Spannungssignal über der Induktivität zugeführt. Schliesslich ist bezüglich eines jeden Phasenbausteins eine erste Berechnungseinheit zur Bildung des Spannungssignals über der Induktivität aus dem Stromzwischensollwert des Stromes durch den Phasenbaustein vorgesehen. Alternativ dazu ist es auch denkbar, dass für sämtliche Phasenbaustein eine gemeinsame erste Berechnungseinheit zur Bildung des Spannungssignals über der Induktivität des jeweils zugehörigen Phasenbausteins aus dem Stromzwischensollwert des Stromes durch den Phasenbaustein vorgesehen ist.

Die erfindungsgemässe Vorrichtung zur Durchführung des Verfahrens zum Betrieb der Umrichterschaltung ist somit sehr einfach und kostengünstig realisierbar, da der Schaltungsaufwand äusserst gering gehalten werden kann und zudem nur eine geringe Anzahl an Bauelementen für den Aufbau benötigt wird. Mittels dieser Vorrichtung ist das erfindungsgemässe Verfahren somit besonders einfach durchführbar.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

## Kurze Beschreibung der Zeichnungen

Es zeigen:

Fig. 1    eine erste Ausführungsform einer erfindungsgemässen Vorrichtung zur Durchführung des erfindungsgemässen Verfahrens zum Betrieb einer Umrichterschaltung,

Fig. 2    eine zweite Ausführungsform einer erfindungsgemässen Vorrichtung zur Durchführung des erfindungsgemässen Verfahrens zum Betrieb einer Umrichterschaltung,

Fig. 3    eine erste Ausführungsform einer Umrichterschaltung, insbesondere eines Direktumrichters,

Fig. 4    eine zweite Ausführungsform einer Umrichterschaltung, insbesondere eines Direktumrichters und

Fig. 5    eine dritte Ausführungsform einer Umrichterschaltung, insbesondere eines Direktumrichters.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

**Wege zur Ausführung der Erfindung**

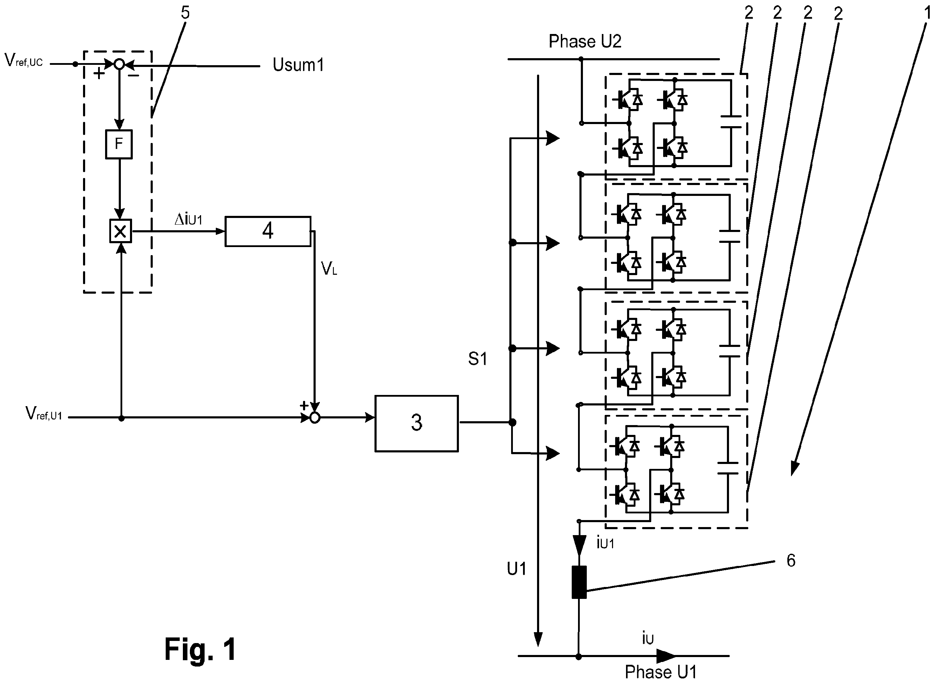

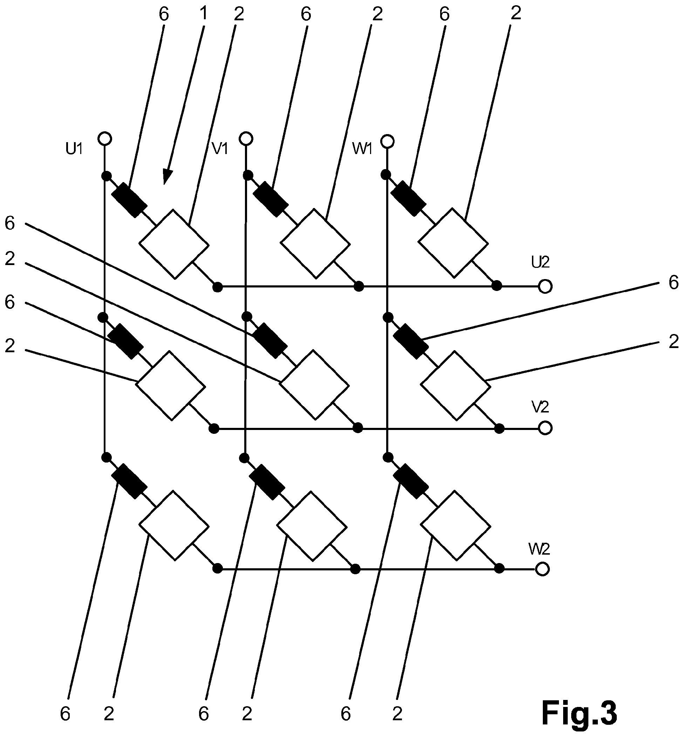

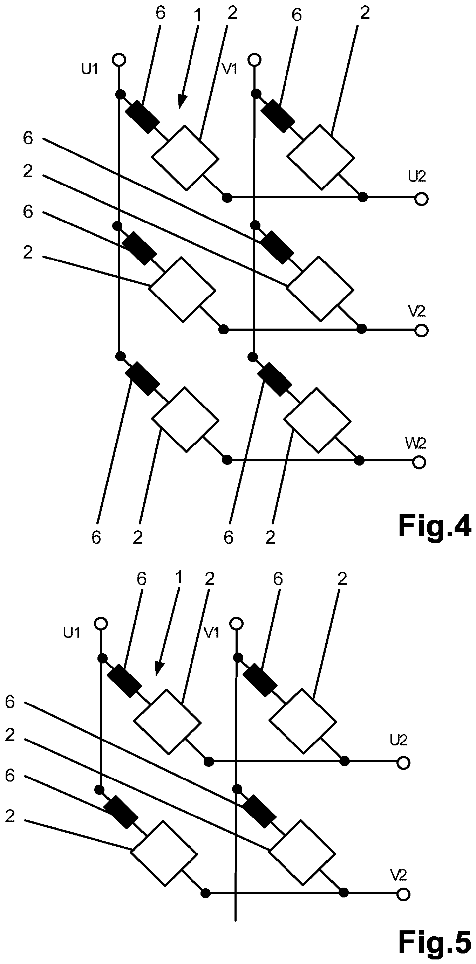

Fig. 1 zeigt eine erste Ausführungsform einer erfindungsgemässen Vorrichtung zur Durchführung des erfindungsgemässen Verfahrens zum Betrieb einer Umrichterschaltung, wobei in Fig. 1 der Übersichtlichkeit halber nur ein Phasenbaustein 1 der Umrichterschaltung gezeigt ist, auf den nachfolgend noch näher eingegangen wird. Die Umrichterschaltung, welche insbesondere ein Direktumrichter ist, der eine Eingangsspannung bzw. ein Eingangsstrom einer ersten Amplitude und einer ersten Frequenz direkt in eine Ausgangsspannung bzw. in einen Ausgangsstrom einer zweiten Amplitude und einer zweiten Frequenz umzuwandeln in der Lage ist, umfasst allgemein n Eingangsphasenanschlüssen U1, V1, W1 und p Ausgangsphasenanschlüssen U2, V2, W2, wobei $n \geq 2$ und $p \geq 2$ ist. Weiterhin umfasst die Umrichterschaltung, welche insbesondere als Direktumrichter ausgeführt ist, $n \cdot p$ zweipoligen Schaltzellen 2 zum Schalten mindestens einer positiven und mindestens einer negativen Spannung zwischen den Polen, wobei jeder Ausgangsphasenanschluss U2, V2, W2 mit jedem Eingangsphasenanschluss U1, V1, W1 jeweils über eine Schaltzelle 2 seriell verbunden ist. In Fig. 3 ist diese serielle Verbindung für eine Umrichterschaltung mit n=3 Eingangsphasenanschlüssen U1, V1, W1 und p=3 Ausgangsphasenanschlüssen U2, V2, W2 beispielhaft gezeigt. Ferner zeigt Fig. 4 eine Umrichterschaltung mit n=2 Eingangsphasenanschlüssen U1, V1 und p=3 Ausgangsphasenanschlüssen U2, V2, W2, und Fig. 3 zeigt eine Umrichterschaltung mit n=2 Eingangsphasenanschlüssen U1, V1 und p=2 Ausgangsphasenanschlüssen U2, V2. Jede Schaltzelle 2 weist allgemein ansteuerbare bidirektionale Leistungshalbleiterschalter mit gesteuerter unidirektionaler Stromführungsrichtung und einen kapazitiven Energiespeicher auf. Der jeweilige ansteuerbare Leistungshalbleiterschalter ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar, einen ansteuerbaren Leistungshalbleiterschalter beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden.

Verfahrensmässig werden für jeden Phasenbaustein 1 die Leistungshalbleiterschalter der Schaltzellen 2 mittels eines Ansteuersignals S1 angesteuert. Das Ansteuersignal S1 ist für jede Schaltzelle 2 vorzugsweise zeitlich versetzt, so dass jede Schaltzelle 2 vorteilhaft zeitlich versetzt angesteuert werden kann.

Erfindungsgemäss ist in jede serielle Verbindung, d.h., wie vorstehend erwähnt, in die jeweilige Verbindung zwischen einem Ausgangsphasenanschluss U2, V2, W2 und einem Eingangsphasenanschluss U1, V1, W1 über die zugehörigen zweipolige Schaltzelle 2, mindestens eine Induktivität 6 eingeschaltet, wobei jeweils eine Schaltzelle 2 mit einer solchen Induktivität 6 einen Phasenbaustein 1 bildet, und für jeden Phasenbaustein 1 wird das Ansteuersignal S1 aus einem Referenzsignal $V_{ref, U1}$ bezüglich der Spannung U1 über dem Phasenbaustein 1 und aus einem Spannungssignal $V_L$ über der Induktivität 6 gebildet. Zudem wird das Spannungssignal $V_L$ über der Induktivität 6 aus einem Stromzwischensollwert $\Delta i_{U1}$ des Stromes $i_{U1}$ durch den Phasenbaustein 1 gebildet. Der Stromzwischensollwert $\Delta i_{U1}$ ist demnach eine Zwischengrösse. Die Induktivität 6 in jeder seriellen Verbindung, d.h. in jedem Zweig zwischen einem Eingangsphasenanschluss U1, V1, W1 und einem Ausgangsphasenanschluss U2, V2, W2 ermöglicht vorteilhaft eine Spannungseinstellung durch die Schaltzellen 2 derart, dass ein kontinuierlicher Stromfluss von einem Eingangsphasenanschluss U1, V1, W1 zu einem Ausgangsphasenanschluss U2, V2, W2 erreicht werden kann, wodurch eine aktive Stromeinstellung durch den jeweiligen Zweig möglich ist. Darüber hinaus ist mit der Umrichterschaltung ein nahezu beliebiger Austausch elektrischer Energie zwischen einzelnen Zweigen möglich. Dadurch, dass der jeweilige Stromzwischensollwert $\Delta i_{U1}$ an dem zugehörigen Phasenbaustein 1 in die Bildung des Spannungssignals $V_L$ über der Induktivität 6 und damit in die Bildung des jeweiligen Ansteuersignals S1 eingeht, kann erreicht werden, dass unerwünschte Kreisströme durch den Phasenbaustein 1 der Umrichterschaltung sich vorteilhaft reduzieren lassen bzw. zu Null geregelt werden können.. Vorteilhafterweise werden durch die vorstehend genannten Verfahrensschritte keine unerwünschten Änderung der Ströme $i_u$ an den Ausgangsphasenanschlüssen U2, V2, W2 der Phasenbausteine 1 hervorrufen, d.h. es findet keine unerwünschte Beeinflussung dieser Ströme $i_u$ statt. Zudem kann die Wirkung der für die Regelung benötigten Kreisströme auf die Ströme $i_u$ in den Ausgangsphasenanschlüssen U2, V2, W2 mit Vorteil beeinflusst bzw. genau vorgegeben werden.

Zur Bildung des Spannungssignals $V_L$ über der Induktivität 6 wird folgende Formel verwendet:

$$V_L = L \cdot \frac{d}{dt} \Delta i_{u1} \qquad\qquad [1]$$

Es findet somit quasi eine Vorsteuerung des Stromes $i_{u1}$ durch den Phasenbaustein 1 statt.

Gemäss Fig. 1 weist jede Schaltzelle 2 beispielhaft vier nach Art einer Brückenschaltung, insbesondere Vollbrückenschaltung, verbundene ansteuerbare bidirektionale Leistungshalbleiterschalter mit gesteuerter unidirektionaler Stromführungsrichtung und einen zu der Brückenschaltung der Leistungshalbleiterschalter parallel geschalteten kapazitiven Energiespeicher auf, wobei der Phasenbaustein 1 zusätzlich allgemein mindestens eine weitere in die serielle Verbindung eingeschaltete zweipolige Schaltzelle 2 zum Schalten mindestens einer positiven und mindestens einer negativen Spannung zwischen den Polen aufweist, wobei in Fig. 1 dazu beispielhaft vier Schaltzellen eines Phasebausteins 1 gezeigt sind. Denkbar sind aber auch zweipolige Schaltzellen 2, die allgemein als Multilevelschaltungen ausgebildet sind mindestens eine positiven und mindestens einer negative Spannung zwischen den Polen zu schalten in der Lage sind. Mittels des bereits vorstehend erwähnten nahezu beliebigen Austauschs elektrischer Energie zwischen einzelnen Zweigen und damit zwischen einzelnen Schaltzellen 2 können bei einer Umrichterschaltung, insbesondere ausgeführt als Direktumrichter, die grosse elektrische Energiemengen zu übertragen in der Lage sein soll, die kapazitiven Energiespeicher der Schaltzellen 2 vorteilhaft entsprechend klein dimensioniert werden, woraus eine signifikante Platzeinsparung und eine deutliche Reduzierung der Kosten gegenüber bekannten Direktumrichtern folgt. Systeme, aufgebaut mit derartigen Umrichterschaltungen, können dadurch ebenfalls einen entsprechend geringen Platzbedarf aufweisen und entsprechend kostengünstig sein. Desweiteren bilden alle Phasenbausteine 1 zu jeder Zeit geschlossene Spannungsmaschen. Etwaige Spannungsunterschiede der einzelnen Schaltzellen 2 fallen über den Induktivitäten 6 ab. Gleichzeitig stellen die kontinuierlichen Ströme durch die Induktivitäten 6 sicher, dass der Strom an den Ausgangsphasenschlüssen U2, V2, W2 der Phasenbausteine 1 niemals unterbrochen wird.

In einer der Übersichtlichkeit nicht dargestellten Ausführungsform der Umrichterschaltung, insbesondere ausgebildet als Direktumrichter, ist in jede serielle Verbindung mindestens eine weitere zweipolige Schaltzelle 2 zum Schalten mindestens einer positiven und mindestens einer negativen Spannung zwischen den Polen eingeschaltet, wodurch die zu schaltende Spannung, d.h. die Spannungstragfähigkeit, über der gesamten seriellen Verbindung zwischen einem Eingangsphasenanschluss U1, V1, W1 und einem Ausgangsphasenanschluss U2, V2, W2 vorteilhaft erhöht werden kann. Denkbar ist es auch, dass zu jeder Schaltzelle 2 mindestens eine weitere zweipolige Schaltzelle 2, beispielsweise wie vorstehend beschrieben ausgebildet, zum Schalten mindestens einer positiven und mindestens einer negativen Spannung zwischen den Polen parallel geschaltet ist. Dadurch lässt sich mit Vorteil ein höherer Strom, d.h. eine erhöhte Stromtragfähigkeit, durch die gesamte serielle Verbindung zwischen einem Eingangsphasenanschluss U1, V1, W1 und einem Ausgangsphasenanschluss U2, V2, W2 erreichen. Möglich ist es auch, dass zu jeder Serienschaltung der Schaltzelle 2 mit mindestens einer Induktivität 6 mindestens eine weitere Serienschaltung einer zweipoligen Schaltzelle 2 zum Schalten mindestens einer positiven und mindestens einer negativen Spannung zwischen den Polen mit mindestens einer weiteren Induktivität 6 parallel geschaltet ist.

Zum Schutz im Fehlerfall einer Schaltzelle 2 kann vorzugsweise parallel zu jeder Schaltzelle 2 ein Kurzschlusselement geschaltet sein.

Dadurch, dass der jeweilige Stromzwischensollwert $\Delta i_{U1}$ an dem zugehörigen Phasenbaustein 1 in die Bildung des Spannungssignals $V_L$ über der Induktivität 6 und damit in die Bildung des Ansteuersignals S1 eingeht, kann zudem vorteilhaft erreicht werden, dass die mittlere Spannungsabweichung der kapazitiven Energiespeicher aller Schaltzellen 2 eines Phasenbausteins 1 gemäss den vorstehend genannten Varianten eines Phasenbausteins 1 mit mehrerer Schaltzellen 2 zu Null geregelt werden.

Für jeden Phasenbaustein 1, der gemäss den vorstehend genannten Varianten mehrere Schaltzellen 2 aufweist, wird der Stromzwischensollwert $\Delta i_{U1}$ des Stromes $i_{U1}$ durch den Phasenbaustein 1 aus einer Summe Usum1 der Spannungen UC1 über den kapazitiven Energiespeichern der Schaltzellen 2 des Phasenbausteins 1 und aus einem Summenspannungssollwert $V_{ref,UC}$ gebildet. Dies geschieht nach folgender Formel:

$$\Delta i_{u1} = F \cdot (V_{ref,UC} - Usum1) \cdot V_{ref,U1} \qquad\qquad [2]$$

Ist lediglich eine einzige Schaltzelle 2 für einen Phasenbaustein 1 vorgesehen, so entspricht die Summe Usum1 logischerweise der Spannung UC1 über dem kapazitiven Energiespeichern dieser einzigen Schaltzelle 2 des Phasenbausteins 1.

Nach der Formel [2] wird der Stromzwischensollwert $\Delta i_{U1}$ des Stromes $i_{U1}$ durch den Phasenbaustein 1 zusätzlich aus einer vorgebbaren Reglerfunktion F gebildet. Vorzugsweise wird für die Reglerfunktion F eine Proportionalcharakteristik gewählt, so dass die Reglerfunktion F beispielsweise als

$$F = K$$

gewählt wird, wobei K ein Proportionalitätsfaktor ist. Selbstverständlich ist es denkbar, allgemein jedwede Reglercharakteristik bezüglich der Reglerfunktion F zu wählen. Durch die Wahl der Reglerfunktion F kann vorteilhaft eine sehr spezifische und beispielsweise auf eine bestimmte Anwendung der Umrichterschaltung gerichtete Reglercharakteristik vorgegeben werden.

Das Referenzsignal $V_{ref, U1}$ bezüglich der Spannung U1 über den Phasenbausteinen 1 wird typischerweise von einer übergeordneten Regelung zu Regelung des Stromes $i_{U1}$ durch den jeweiligen Phasenbaustein 1 erzeugt, so dass das erfindungsgemässe Verfahren der Stromregelung unterlagert ist.

Die erfindungsgemässe Vorrichtung zur Durchführung des Verfahrens zum Betrieb der Umrichterschaltung weist eine der Erzeugung des Ansteuersignals S1 dienende Ansteuerschaltung 3 für jeden Phasenbaustein 1 auf, welche Ansteuerschaltung 3 mit den Leistungshalbleiterschaltern der Schaltzelle 2 des Phasenbausteins 1 verbunden ist. Gemäss der Ausführungsform nach Fig. 1 Fig. 1 ist bei einem Phasenbaustein 1 mit mehreren Schaltzellen 2 ist die Ansteuerschaltung 3 dann mit den Leistungshalbleiterschaltern der Schaltzellen 2 des Phasenbausteins 1 verbunden. Nach der Erfindung ist bezüglich eines jeden Phasenbausteins 1 der Ansteuerschaltung 3 zur Bildung des Ansteuersignals S1 die Summe aus dem Referenzsignal $V_{ref, U1}$ bezüglich der Spannung U1 über dem Phasenbaustein 1 und aus dem Spannungssignal $V_L$ über der Induktivität 6 zugeführt. Ferner ist bezüglich eines jeden Phasenbausteins 1 eine erste Berechnungseinheit 4 zur Bildung des Spannungssignals $V_L$ über der Induktivität 6 aus dem Stromzwischensollwert $\Delta i_{U1}$ des Stromes $i_{U1}$ durch den Phasenbaustein 1 vorgesehen. Die erste Berechnungseinheit 4 bildet das Spannungssignal $V_L$ über der Induktivität 6, insbesondere gemäss Formel [1], aus dem Stromzwischensollwert $\Delta i_{U1}$ des Stromes $i_{U1}$ durch den Phasenbaustein 1.

Darüber hinaus ist gemäss Fig. 1 für jeden Phasenbaustein 1 eine zweite Berechnungseinheit 5 zur Bildung des Stromzwischensollwertes $\Delta i_{U1}$ des Stromes $i_{U1}$ durch den Phasenbaustein 1 aus der Summe Usum1 der Spannungen UC1 über den kapazitiven Energiespeichern der Schaltzellen 2 des Phasenbausteins 1 und aus dem Summenspannungssollwert $V_{ref,UC}$ vorgesehen, wobei die Bildung des Stromzwischensollwertes $\Delta i_{U1}$ des Stromes $i_{U1}$ durch den Phasenbaustein 1 insbesondere mittels der Formel [2] erfolgt.

Die zweite Berechnungseinheit 5 bildet den Stromzwischensollwert $\Delta i_{U1}$ des Stromes $i_{U1}$ durch den Phasenbaustein 1 zusätzlich aus der vorgebbaren Reglerfunktion F, wie insbesondere Formel [2] zeigt.

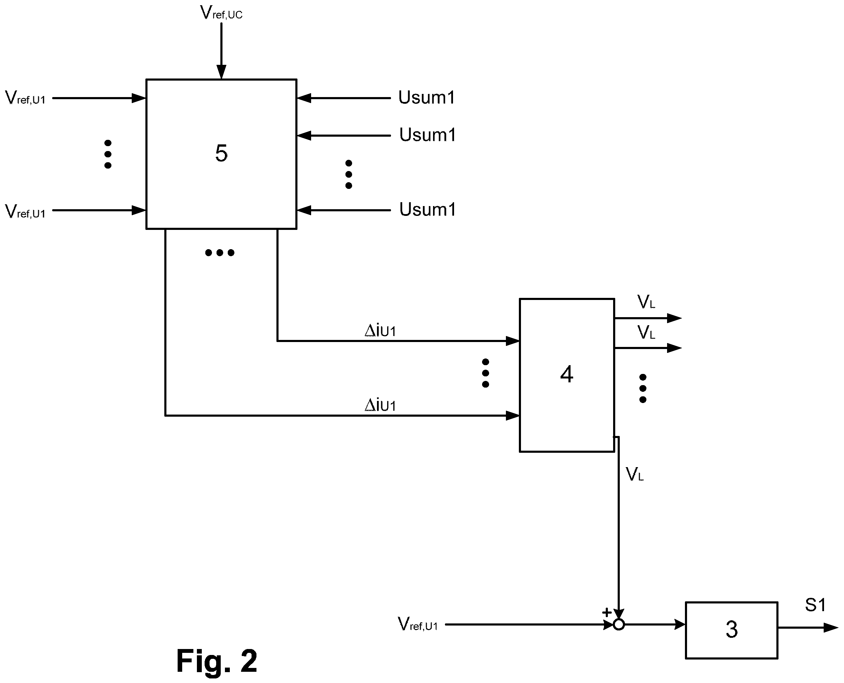

Eine alternative Ausführungsform der erfindungsgemässen Vorrichtung zu Fig. 1 ist in Fig. 2 gezeigt. Im Unterschied zu Fig. 1 ist nach der alternativen Ausführungsform in Fig. 2 nun für sämtliche Phasenbausteine 1 eine gemeinsame erste Berechnungseinheit 4 zur Bildung des Spannungssignals $V_L$ über der Induktivität 6 des jeweils zugehörigen Phasenbausteins 1 aus dem Stromzwischensollwert $\Delta i_{U1}$ des Stromes $i_{U1}$ durch den Phasenbaustein 1 vorgesehen. Die Bildung der Spannungssignale $V_L$ über den Induktivitäten 6 der Phasenbausteine 1 findet somit vorteilhaft zentral in einer einzigen Einheit statt. Wie in Fig. 2 dargestellt werden der gemeinsamen ersten Berechnungseinheit 4 dazu die Summen der Stromzwischensollwerte $\Delta i_{U1}$ der Ströme $i_{U1}$ durch die Phasenbausteine 1 zugeführt. Die gemeinsame erste Berechnungseinheit 4 bildet dann das Spannungssignals $V_L$ über der Induktivität 6 des jeweils zugehörigen Phasenbausteins 1 aus der jeweiligen Summe der Stromzwischensollwerte $\Delta i_{U1}$ des Stromes $i_{U1}$ durch den jeweils zugehörigen Phasenbaustein 1. Die gemeinsame erste Berechnungseinheit 4 bildet das Spannungssignals $V_L$ über der Induktivität 6 des jeweils zugehörigen Phasenbausteins 1 insbesondere gemäss Formel [1].

Desweiteren ist gemäss Fig. 2 für sämtliche Phasenbausteine 1 eine gemeinsame zweite Berechnungseinheit 5 zur Bildung des Stromzwischensollwertes $\Delta i_{U1}$ des Stromes $i_{U1}$ durch alle Phasenbausteine 1 aus einer Summe Usum1 der Spannungen UC1 über den kapazitiven Energiespeichern der Schaltzellen 3 der Phasenbausteine 1 und aus dem Summenspannungssollwert $V_{ref,UC}$ vorgesehen, wobei die Bildung des Stromzwischensollwertes $\Delta i_{U1}$ des Stromes $i_{U1}$ durch die Phasenbausteine 1 insbesondere mittels der nachfolgenden Formel [3] erfolgt:

$$\Delta \vec{i}_{U1} = V_{\sigma=0} \cdot V_{\sigma=0}^{T} \cdot F \cdot \left( V_{ref,UC} - \vec{U}sum1 \right) \cdot \vec{V}_{ref,U1} \qquad [3]$$

Die Bildung des Stromzwischensollwertes $\Delta i_{U1}$ findet damit mit Vorteil zentral in einer einzigen Einheit statt. Es sei erwähnt, dass Formel [3] als Vektorgleichung dargestellt ist und die Stromzwischensollwerte $\Delta i_{U1}$ der Phasenbausteine 1 Elemente des Stromzwischensollwertvektors $\Delta \vec{i}_{U1}$ sind, dass die Summen Usum1 der Phasenbausteine 1 Elemente des Summenspannungsvektors Usum1 sind, und dass die Referenzsignale $V_{ref, U1}$ Elemente des Referenzsignalvektors $\vec{V}_{ref,U1}$ sind.

Die gemeinsame zweite Berechnungseinheit 5 bildet der Stromzwischensollwert $\Delta i_{U1}$ des Stromes $i_{U1}$ durch die Phasenbausteine 1 zusätzlich aus einer vorgebbaren Reglerfunktion F, insbesondere gemäss Formel [3].

Gemäss Formel [3] wird der Stromzwischensollwert $\Delta i_{U1}$ des Stromes $i_{U1}$ durch den Phasenbaustein 1 verfahrensmässig zusätzlich jeweils aus einer vorgebbaren Entkopplungsmatrix V gebildet, welche der Entkopplung der Kreisströme durch die Phasenbausteine 1 von den Strömen $i_u$ in den Ausgangsphasenanschlüssen U2, V2, W2 dient. Vorab wird der Stromzwischensollwert $\Delta i_{U1}$ in einen Unterraum abgebildet, der orthogonal zu denjenigen Strömen $i_U$ an den Ausgangsanschlüssen U2, V2, W2 der Phasenbausteine 9 ist, die nicht verändert werden sollen. Ein solcher Unterraum und die für die Abbildung nötige Entkopplungsmatrix V können beispielsweise aus einer Verbindungsmatrix T vorab berechnet werden, wobei dann die Singulärwertzerlegung von T folgendermassen definiert ist:

$$T = U \Sigma V^*$$

und U eine unitäre Matrix, $V^*$ die Adjungierte der unitären Matrix V und $\Sigma$ eine reelle Matrix ist, wobei alle Elemente von $\Sigma$ abseits der Hauptdiagonalen gleich null sein müssen. $V_{\sigma=0}$ seien jene Spalten von V, deren Singulärwert (das zugehörige Element in $\Sigma$) gleich null ist. $V_{\sigma=0}$ sind besagte Spalten der Entkopplungsmatrix V, welche eine Basis des Unterraums der Stromzwischensollwerte $\Delta i_{U1}$ ist, welcher Unterraum orthogonal zu denjenigen Strömen $i_U$ an den Ausgangsanschlüssen der Phasenbausteine 9 ist. $V^T_{\sigma=0}$ ist dann die Transponierte von $V_{\sigma=0}$.

Für eine Umrichterschaltung, insbesondere Direktumrichterschaltung beispielsweise nach Fig. 3 kann die Verbindungsmatrix T folgendermassen aufgestellt werden:

$$T = \begin{pmatrix} +1 & 0 & 0 & +1 & 0 & 0 & +1 & 0 & 0 \\ 0 & +1 & 0 & 0 & +1 & 0 & 0 & +1 & 0 \\ 0 & 0 & +1 & 0 & 0 & +1 & 0 & 0 & +1 \\ -1 & -1 & -1 & 0 & 0 & 0 & 0 & 0 & 0 \\ 0 & 0 & 0 & -1 & -1 & -1 & 0 & 0 & 0 \\ 0 & 0 & 0 & 0 & 0 & 0 & -1 & -1 & -1 \end{pmatrix}$$

und $V_{\sigma=0}$ beispielhaft folgendermassen aufgestellt werden:

$$V_{\sigma=0} = \begin{pmatrix} 0.3800 & -0.2239 & 0.3535 & 0.3535 \\ -0.4316 & 0.3019 & -0.2754 & 0.3019 \\ 0.0515 & -0.0781 & -0.0781 & -0.6554 \\ -0.5191 & -0.3609 & -0.1495 & -0.1495 \\ 0.5895 & -0.0791 & -0.2905 & -0.0791 \\ -0.0704 & 0.4400 & 0.4400 & 0.2287 \\ 0.1391 & 0.5847 & -0.2039 & -0.2039 \\ -0.1580 & -0.2228 & 0.5659 & -0.2228 \\ 0.0189 & -0.3619 & -0.3619 & 0.4268 \end{pmatrix}$$

Vorteilhafterweise werden durch die vorstehend genannte Bildung der Stromzwischensollwerte $\Delta i_{U1}$ gemäss Formel [3] keine Änderung der Ströme $i_u$ an den Ausgangsanschlüssen der Phasenbausteine 9 hervorrufen, d.h. es findet keine Beeinflussung dieser Ströme $i_u$ statt.

Nach Fig. 2 bildet dann die gemeinsame zweite Berechnungseinheit 5 den Stromzwischensollwert $\Delta i_{U1}$ des Stromes $i_{U1}$ durch Phasenbausteine 1 zusätzlich aus der vorgebbaren Entkopplungsmatrix V, insbesondere gemäss Formel [3]. Die Stromzwischensollwerte $\Delta i_{U1}$ werden somit gleichzeitig durch die Matrix V entkoppelt.

Insgesamt konnte gezeigt werden, dass die, insbesondere in Fig. 1 und Fig. 2 gezeigten, erfindungsgemässen Vorrichtungen zur Durchführung des erfindungsgemässen Verfahrens zum Betrieb der Umrichterschaltung sehr einfach und kostengünstig realisiert werden können, da der Schaltungsaufwand äusserst gering ist und zudem nur eine geringe Anzahl an Bauelementen für den Aufbau benötigt wird. Somit ist mit diesen Vorrichtungen das erfindungsgemässe Verfahren besonders einfach durchführbar.

**Bezugszeichenliste**

1 Phasenbaustein
2 Schaltzelle
3 Ansteuerschaltung
4 erste Berechnungseinheit
5 zweite Berechnungseinheit
6 Induktivität

**Patentansprüche**

1. Verfahren zum Betrieb einer Umrichterschaltung, wobei die Umrichterschaltung n Eingangsphasenanschlüsse (U1, V1, W1) und p Ausgangsphasenanschlüsse (U2, V2, W2) aufweist, wobei $n \geq 2$ und $p \geq 2$ ist, (n·p) zweipolige Schaltzellen (2) zum Schalten mindestens einer positiven und mindestens einer negativen Spannung zwischen den Polen umfasst, wobei jeder Ausgangsphasenanschluss (U2, V2, W2) mit jedem Eingangsphasenanschluss (U1, V1, W1) jeweils über eine Schaltzelle (2) seriell verbunden ist, und jede Schaltzelle (2) ansteuerbare bidirektionale Leistungshalbleiterschalter mit gesteuerter unidirektionaler Stromführungsrichtung und einen kapazitiven Energiespeicher aufweist,
bei dem die Leistungshalbleiterschalter der Schaltzellen (2) mittels eines Ansteuersignals (S1) angesteuert werden, wobei in jede serielle Verbindung des jeweiligen Ausgangsphasenanschluss (U2, V2, W2) mit der zugehörigen Schaltzelle (2) und dem jeweiligen Eingangsphasenanschluss (U1, V1, W1) mindestens eine Induktivität (6) eingeschaltet ist, wobei jeweils eine Schaltzelle (2) mit einer solchen Induktivität (6) einen Phasenbaustein (1) bildet, und für jeden Phasenbaustein (1) das Ansteuersignal (S1) aus einem Referenzsignal ($V_{ref,\,U1}$) bezüglich der Spannung (U1) über dem Phasenbaustein (1) und aus einem Spannungssignal ($V_L$) über der Induktivität (6) des Phasenbausteins gebildet wird, wobei das Spannungssignal ($V_L$) über der Induktivität (6) des Phasenbausteins aus einem Stromzwischensollwert ($\Delta i_{U1}$) des Stromes ($i_{U1}$) durch den Phasenbaustein (1) gebildet wird, und wobei jede Schaltzelle (2) vier nach Art einer Brückenschaltung verbundene ansteuerbare bidirektionale Leistungshalbleiterschalter mit gesteuerter unidirektionaler Stromführungsrichtung und einen zu der Brückenschaltung der Leistungshalbleiterschalter parallel geschalteten kapazitiven Energiespeicher aufweist, der Phasenbaustein (1) zusätzlich mindestens eine weitere in die serielle Verbindung eingeschaltete zweipolige Schaltzelle (2) zum Schalten mindestens einer positiven und mindestens einer negativen Spannung zwischen den Polen aufweist,
**dadurch gekennzeichnet, dass** der Stromzwischensollwert ($\Delta i_{U1}$) des Stromes ($i_{U1}$) durch den Phasenbaustein (1) aus einer Summe (Usum1) der Spannungen (UC1) über den kapazitiven Energiespeichern der Schaltzellen (2) des Phasenbausteins (1), aus einem Summenspannungssollwert ($V_{ref,UC}$) und aus dem Referenzsignal ($V_{ref,U1}$) bezüglich der Spannung (U1) über dem Phasenbaustein nach der Formel $\Delta i_{u1}=F\cdot(V_{ref,UC}-Usum1)\cdot V_{ref,U1}$ gebildet wird, wobei F eine vorgebbare Reglerfunktion ist.

2. Verfahren zum Betrieb einer Umrichterschaltung, wobei die Umrichterschaltung n Eingangsphasenanschlüsse (U1, V1, W1) und p Ausgangsphasenanschlüsse (U2, V2, W2) aufweist, wobei $n \geq 2$ und $p \geq 2$ ist, (n·p) zweipolige Schaltzellen (2) zum Schalten mindestens einer positiven und mindestens einer negativen Spannung zwischen den Polen umfasst, wobei jeder Ausgangsphasenanschluss (U2, V2, W2) mit jedem Eingangsphasenanschluss (U1, V1, W1) jeweils über eine Schaltzelle (2) seriell verbunden ist, und jede Schaltzelle (2) ansteuerbare bidirektionale Leistungshalbleiterschalter mit gesteuerter unidirektionaler Stromführungsrichtung und einen kapazitiven Energiespeicher aufweist,
bei dem die Leistungshalbleiterschalter der Schaltzellen (2) mittels eines Ansteuersignals (S1) angesteuert werden, wobei in jede serielle Verbindung des jeweiligen Ausgangsphasenanschluss (U2, V2, W2) mit der zugehörigen Schaltzelle (2) und dem jeweiligen Eingangsphasenanschluss (U1, V1, W1) mindestens eine Induktivität (6) eingeschaltet ist, wobei jeweils eine Schaltzelle (2) mit einer solchen Induktivität (6) einen Phasenbaustein (1) bildet, und für jeden Phasenbaustein (1) das Ansteuersignal (S1) aus einem Referenzsignal ($V_{ref,\,U1}$) bezüglich der Spannung (U1) über dem Phasenbaustein (1) und aus einem Spannungssignal ($V_L$) über der Induktivität (6) des Phasenbausteins gebildet wird, wobei jedes Spannungssignal ($V_L$) über der Induktivität (6) des jeweils zugehörigen Phasenbausteins aus der jeweiligen Summe der Stromzwischensollwerte ($\Delta i_{U1}$) des Stromes ($i_{U1}$) durch den jeweils zugehörigen Phasenbaustein (1) gebildet wird, und wobei jede Schaltzelle (2) vier nach Art einer Brückenschaltung verbundene ansteuerbare bidirektionale Leistungshalbleiterschalter mit gesteuerter unidirektionaler Stromführungsrichtung und einen zu der Brückenschaltung der Leistungshalbleiterschalter parallel geschalteten kapazitiven Energiespeicher aufweist, der Phasenbaustein (1) zusätzlich mindestens eine weitere in die serielle Verbindung eingeschaltete zweipolige Schaltzelle (2) zum Schalten mindestens einer positiven und mindestens einer negativen Spannung zwischen den Polen aufweist,

**dadurch gekennzeichnet, dass** der Stromzwischensollwert $(\Delta\overrightarrow{i_{U1}})$ des Stromes ($i_{U1}$) durch alle Phasenbausteine (1) aus einer Summe $(\vec{U}sum1)$ der Spannungen (UC1) über den kapazitiven Energiespeichern der Schaltzellen (3) der Phasenbausteine (1), aus einem Summenspannungssollwert ($V_{ref,UC}$) und aus dem Referenzsignal ($V_{ref,U1}$) bezüglich der Spannungen (U1) über den Phasenbausteinen nach der Formel

$$\Delta\vec{i}_{U1} = V_{\sigma=0} \cdot V_{\sigma=0}^{T} \cdot F \cdot \left(V_{ref,UC} - \vec{U}sum1\right) \cdot \vec{V}_{ref,U1}$$

gebildet wird, wobei F eine vorgebbare Reglerfunktion ist, und wobei V eine vorgebbare Entkopplungsmatrix ist, welche der Entkopplung von Kreisströmen durch die Phasenbausteine (1) von den Strömen ($i_u$) in den Ausgangsphasenanschlüssen (U2, V2, W2) dient.

3. Vorrichtung zur Durchführung eines Verfahrens zum Betrieb einer Umrichterschaltung, wobei die Umrichterschaltung n Eingangsphasenanschlüsse (U1, V1, W1) und p Ausgangsphasenanschlüsse (U2, V2, W2) aufweist, wobei n ≥ 2 und p ≥ 2 ist, (n·p) zweipolige Schaltzellen (2) zum Schalten mindestens einer positiven und mindestens einer negativen Spannung zwischen den Polen umfasst, wobei jeder Ausgangsphasenanschluss (U2, V2, W2) mit jedem Eingangsphasenanschluss (U1, V1, W1) jeweils über eine Schaltzelle (2) seriell verbunden ist, und jede Schaltzelle (2) ansteuerbare bidirektionale Leistungshalbleiterschalter mit gesteuerter unidirektionaler Stromführungsrichtung und einen kapazitiven Energiespeicher aufweist, mit einer der Erzeugung eines Ansteuersignals (S1) dienenden Ansteuerschaltung (3), welche Ansteuerschaltung (3) mit den Leistungshalbleiterschaltern der Schaltzelle (2) verbunden ist, wobei in jede serielle Verbindung des jeweiligen Ausgangsphasenanschluss (U2, V2, W2) mit der zugehörigen Schaltzelle (2) und dem jeweiligen Eingangsphasenanschluss (U1, V1, W1) mindestens eine Induktivität (6) eingeschaltet ist, wobei jeweils eine Schaltzelle (2) mit einer solchen Induktivität (6) einen Phasenbaustein (1) bildet, und bezüglich eines jeden Phasenbausteins (1) der Ansteuerschaltung (3) zur Bildung des Ansteuersignals (S1) die Summe aus einem Referenzsignal ($V_{ref, U1}$) bezüglich der Spannung (U1) über dem Phasenbaustein (1) und aus einem Spannungssignal ($V_L$) über der Induktivität (6) des Phasenbausteins zugeführt ist, wobei bezüglich eines jeden Phasenbausteins (1) eine erste Berechnungseinheit (4) zur Bildung des Spannungssignals ($V_L$) über der Induktivität (6) des Phasenbausteins aus einem Stromzwischensollwert ($\Delta i_{U1}$) des Stromes ($i_{U1}$) durch den Phasenbaustein (1) vorgesehen ist, und wobei jede Schaltzelle (2) vier nach Art einer Brückenschaltung verbundene ansteuerbare bidirektionale Leistungshalbleiterschalter mit gesteuerter unidirektionaler Stromführungsrichtung und einen zu der Brückenschaltung der Leistungshalbleiterschalter parallel geschalteten kapazitiven Energiespeicher aufweist, der Phasenbaustein (1) zusätzlich mindestens eine weitere in die serielle Verbindung eingeschaltete zweipolige Schaltzelle (2) zum Schalten mindestens einer positiven und mindestens einer negativen Spannung zwischen den Polen aufweist,

**dadurch gekennzeichnet, dass** für jeden Phasenbaustein (1) eine zweite Berechnungseinheit (5) zur Bildung des Stromzwischensollwertes ($\Delta i_{U1}$) des Stromes ($i_{U1}$) durch den Phasenbaustein (1) aus einer Summe (Usum1) der Spannungen (UC1) über den kapazitiven Energiespeichern der Schaltzellen (2) des Phasenbausteins (1), aus einem Summenspannungssollwert ($V_{ref,UC}$) und aus dem Referenzsignal ($V_{ref,U1}$) bezüglich der Spannung (U1) über dem Phasenbaustein nach der Formel $\Delta i_{u1} = F \cdot (V_{ref,UC} - Usum1) \cdot V_{ref,U1}$ vorgesehen ist, wobei F eine vorgebbare Reglerfunktion ist.

4. Vorrichtung zur Durchführung eines Verfahrens zum Betrieb einer Umrichterschaltung, wobei die Umrichterschaltung n Eingangsphasenanschlüsse (U1, V1, W1) und p Ausgangsphasenanschlüsse (U2, V2, W2) aufweist, wobei n ≥ 2 und p ≥ 2 ist, (n·p) zweipolige Schaltzellen (2) zum Schalten mindestens einer positiven und mindestens einer negativen Spannung zwischen den Polen umfasst, wobei jeder Ausgangsphasenanschluss (U2, V2, W2) mit jedem Eingangsphasenanschluss (U1, V1, W1) jeweils über eine Schaltzelle (2) seriell verbunden ist, und jede Schaltzelle (2) ansteuerbare bidirektionale Leistungshalbleiterschalter mit gesteuerter unidirektionaler Stromführungsrichtung und einen kapazitiven Energiespeicher aufweist, mit einer der Erzeugung eines Ansteuersignals (S1) dienenden Ansteuerschaltung (3), welche Ansteuerschaltung (3) mit den Leistungshalbleiterschaltern der Schaltzelle (2) verbunden ist, wobei in jede serielle Verbindung des jeweiligen Ausgangsphasenanschluss (U2, V2, W2) mit der zugehörigen Schaltzelle (2) und dem jeweiligen Eingangsphasenanschluss (U1, V1, W1) mindestens eine Induktivität (6) eingeschaltet ist, wobei jeweils eine Schaltzelle (2) mit einer solchen Induktivität (6) einen Phasenbaustein (1) bildet, und bezüglich eines jeden Phasenbausteins (1) der Ansteuerschaltung (3) zur Bildung des Ansteuersignals (S1) die Summe aus einem Referenzsignal ($V_{ref, U1}$) bezüglich der Spannung (U1) über dem Phasenbaustein (1) und aus einem Spannungssignal ($V_L$) über der Induktivität (6) des Phasenbausteins zugeführt ist,

wobei für sämtliche Phasenbausteine (1) eine gemeinsame erste Berechnungseinheit (4) zur Bildung des Spannungssignals ($V_L$) über der Induktivität (6) des jeweils zugehörigen Phasenbausteins (1) aus einem Stromzwischensollwert ($\Delta i_{U1}$) des Stromes ($i_{U1}$) durch den Phasenbaustein (1) vorgesehen ist, und

dass jede Schaltzelle (2) vier nach Art einer Brückenschaltung verbundene ansteuerbare bidirektionale Leistungshalbleiterschalter mit gesteuerter unidirektionaler Stromführungsrichtung und einen zu der Brückenschaltung der Leistungshalbleiterschalter parallel geschalteten kapazitiven Energiespeicher aufweist, der Phasenbaustein (1) zusätzlich mindestens eine weitere in die serielle Verbindung eingeschaltete zweipolige Schaltzelle (2) zum Schalten mindestens einer positiven und mindestens einer negativen Spannung zwischen den Polen aufweist, **dadurch gekennzeichnet, dass** für sämtliche Phasenbausteine (1) eine gemeinsame zweite Berechnungseinheit

(5) zur Bildung des Stromzwischensollwertes $(\Delta \overrightarrow{i_{U1}})$ des Stromes ($i_{U1}$) durch alle Phasenbausteine (1) aus einer

Summe $(\vec{U}sum1)$ der Spannungen (UC1) über den kapazitiven Energiespeichern der Schaltzellen (3) der Phasenbausteine (1), aus einem Summenspannungssollwert ($V_{ref,UC}$) und aus dem Referenzsignal ($V_{ref,U1}$) bezüglich der Spannung (U1) über den Phasenbausteinen nach der Formel

$$\Delta \vec{i}_{U1} = V_{\sigma=0} \cdot V_{\sigma=0}^{T} \cdot F \cdot \left(V_{ref,UC} - \vec{U}sum1\right) \cdot \vec{V}_{ref,U1}$$ vorgesehen ist, wobei F eine vorgebbare Reglerfunktion ist, und wobei V eine vorgebbare Entkopplungsmatrix ist, welche der Entkopplung von Kreisströmen durch die Phasenbausteine (1) von den Strömen ($i_u$) in den Ausgangsphasenanschlüssen (U2, V2, W2) dient.

## Claims

1.  Method for operating a converter circuit, with the converter circuit having n input phase connections (U1, V1, W1) and p output phase connections (U2, V2, W2), where $n \geq 2$ and $p \geq 2$, comprising (n·p) two-pole switching cells (2) for switching at least one positive and at least one negative voltage between the poles, with each output phase connection (U2, V2, W2) being connected in series to each input phase connection (U1, V1, W1) in each case by means of a switching cell (2), and each switching cell (2) having drivable bidirectional power semiconductor switches with a controlled unidirectional current guidance direction, and a capacitive energy storage means, in which method the power semiconductor switches of the switching cells (2) are driven by means of a drive signal (S1), wherein at least one inductance (6) is connected into each series connection of the respective output phase connection (U2, V2, W2) with the associated switching cell (2) and the respective input phase connection (U1, V1, W1), with a switching cell (2) together with an inductance (6) of this kind in each case forming a phase module (1), and, for each phase module (1), the drive signal (S1) is formed from a reference signal ($V_{ref, U1}$) in respect of the voltage (U1) across the phase module (1) and from a voltage signal ($V_L$) across the inductance (6) of the phase module, wherein the voltage signal ($V_L$) across the inductance (6) of the phase module is formed from an intermediate setpoint value ($\Delta i_{U1}$) of the current ($i_{U1}$) through the phase module (1), and wherein each switching cell (2) has four drivable bidirectional power semiconductor switches with a controlled unidirectional current guidance direction, which power semiconductor switches are connected in the manner of a bridge circuit, and a capacitive energy storage means which is connected parallel to the bridge circuit of the power semiconductor switches, the phase module (1) additionally has at least one further two-pole switching cell (2), which is connected into the series connection, for switching at least one positive and at least one negative voltage between the poles, **characterized in that** the intermediate setpoint value ($\Delta i_{U1}$) of the current ($i_{U1}$) through the phase module (1) is formed from a sum (Usum1) of the voltages (UC1) across the capacitive energy storage means of the switching cells (2) of the phase module (1), from a sum voltage setpoint value ($V_{ref, UC}$) and from the reference signal ($V_{ref, U1}$) in respect of the voltage (U1) across the phase module in accordance with the formula $\Delta i_{u1} = F \cdot (V_{ref,UC} - Usum1) \cdot V_{ref,U1}$, where F is a predefinable controller function.

2.  Method for operating a converter circuit, with the converter circuit having n input phase connections (U1, V1, W1) and p output phase connections (U2, V2, W2), where $n \geq 2$ and $p \geq 2$, comprising (n·p) two-pole switching cells (2) for switching at least one positive and at least one negative voltage between the poles, with each output phase connection (U2, V2, W2) being connected in series to each input phase connection (U1, V1, W1) in each case by means of a switching cell (2), and each switching cell (2) having drivable bidirectional power semiconductor switches with a controlled unidirectional current guidance direction, and a capacitive energy storage means,

in which method the power semiconductor switches of the switching cells (2) are driven by means of a drive signal (S1), wherein at least one inductance (6) is connected into each series connection of the respective output phase connection (U2, V2, W2) with the associated switching cell (2) and the respective input phase connection (U1, V1, W1), with a switching cell (2) together with an inductance (6) of this kind in each case forming a phase module (1), and, for each phase module (1), the drive signal (S1) is formed from a reference signal ($V_{ref, U1}$) in respect of the voltage (U1) across the phase module (1) and from a voltage signal ($V_L$) across the inductance (6) of the phase module,

wherein each voltage signal ($V_L$) across the inductance (6) of the respectively associated phase module is formed from the respective sum of the intermediate setpoint values ($\Delta i_{U1}$) of the current ($i_{U1}$) through the respectively associated phase module (1), and

wherein each switching cell (2) has four drivable bidirectional power semiconductor switches with a controlled unidirectional current guidance direction, which power semiconductor switches are connected in the manner of a bridge circuit, and a capacitive energy storage means which is connected parallel to the bridge circuit of the power semiconductor switches, the phase module (1) additionally has at least one further two-pole switching cell (2), which is connected into the series connection, for switching at least one positive and at least one negative voltage between the poles, **characterized in that** the intermediate setpoint value $\left(\overrightarrow{\Delta i_{U1}}\right)$ of the current ($i_{U1}$) through all phase modules (1) is formed from a sum $\left(\vec{U}sum1\right)$ of the voltages (UC1) across the capacitive energy storage means of the switching cells (3) of the phase modules (1), from a sum voltage setpoint value ($V_{ref, UC}$) and from the reference signal ($V_{ref, U1}$) in respect of the voltages (U1) across the phase modules in accordance with the formula

$$\vec{\Delta i}_{U1} = V_{\sigma=0} \cdot V_{\sigma=0}^T \cdot F \cdot \left(V_{ref,UC} - \vec{U}sum1\right) \cdot \vec{V}_{ref,U1}$$

where F is a predefinable controller function, and where V is a predefinable decoupling matrix which serves to decouple circulating currents through the phase modules (1) for the currents ($i_u$) in the output phase connections (U2, V2, W2) .

3.  Apparatus for carrying out a method for operating a converter circuit, with the converter circuit having n input phase connections (U1, V1, W1) and p output phase connections (U2, V2, W2), where n ≥ 2 and p ≥ 2, comprising (n·p) two-pole switching cells (2) for switching at least one positive and at least one negative voltage between the poles, with each output phase connection (U2, V2, W2) being connected in series to each input phase connection (U1, V1, W1) in each case by means of a switching cell (2), and each switching cell (2) having drivable bidirectional power semiconductor switches with a controlled unidirectional current guidance direction, and a capacitive energy storage means,

having a drive circuit (3) which serves to generate a drive signal (S1) and which drive circuit (3) is connected to the power semiconductor switches of the switching cell (2),

wherein at least one inductance (6) is connected into each series connection of the respective output phase connection (U2, V2, W2) with the associated switching cell (2) and the respective input phase connection (U1, V1, W1), with a switching cell (2) together with an inductance (6) of this kind in each case forming a phase module (1), and, in respect of each phase module (1), the sum of a reference signal ($V_{ref, U1}$) in respect of the voltage (U1) across the phase module (1) and of a voltage signal ($V_L$) across the inductance (6) of the phase module being supplied to the drive circuit (3) for the purpose of forming the drive signal (S1), wherein, in respect of each phase module (1), a first calculation unit (4) for forming the voltage signal ($V_L$) across the inductance (6) of the phase module from an intermediate setpoint value ($\Delta i_{U1}$) of the current ($i_{U1}$) through the phase module (1) is provided, and

wherein each switching cell (2) has four drivable bidirectional power semiconductor switches with a controlled unidirectional current guidance direction, which power semiconductor switches are connected in the manner of a bridge circuit, and a capacitive energy storage means which is connected parallel to the bridge circuit of the power semiconductor switches, the phase module (1) additionally has at least one further two-pole switching cell (2), which is connected into the series connection, for switching at least one positive and at least one negative voltage between the poles, **characterized in that**, for each phase module (1), a second calculation unit (5) for forming the intermediate setpoint value ($\Delta i_{U1}$) of the current ($i_{U1}$) through the phase module (1) from a sum (Usum1) of the voltages (UC1) across the capacitive energy storage means of the switching cells (2) of the phase module (1), from a sum voltage setpoint value ($V_{ref, UC}$) and from the reference signal ($V_{ref, U1}$) in respect of the voltage (U1) across the phase module in accordance with the formula $\Delta i_{u1}=F \cdot (V_{ref,UC}-Usum1) \cdot V_{ref,U1}$ is provided, where F is a predefinable controller function.

4. Apparatus for carrying out a method for operating a converter circuit, with the converter circuit having n input phase connections (U1, V1, W1) and p output phase connections (U2, V2, W2), where n ≥ 2 and p ≥ 2, comprising (n·p) two-pole switching cells (2) for switching at least one positive and at least one negative voltage between the poles, with each output phase connection (U2, V2, W2) being connected in series to each input phase connection (U1, V1, W1) in each case by means of a switching cell (2), and each switching cell (2) having drivable bidirectional power semiconductor switches with a controlled unidirectional current guidance direction, and a capacitive energy storage means,

having a drive circuit (3) which serves to generate a drive signal (S1) and which drive circuit (3) is connected to the power semiconductor switches of the switching cell (2),

wherein at least one inductance (6) is connected into each series connection of the respective output phase connection (U2, V2, W2) with the associated switching cell (2) and the respective input phase connection (U1, V1, W1), with a switching cell (2) together with an inductance (6) of this kind in each case forming a phase module (1), and, in respect of each phase module (1), the sum of a reference signal ($V_{ref, U1}$) in respect of the voltage (U1) across the phase module (1) and of a voltage signal ($V_L$) across the inductance (6) of the phase module being supplied to the drive circuit (3) for the purpose of forming the drive signal (S1), wherein, for all the phase modules (1), a common first calculation unit (4) for forming the voltage signal ($V_L$) across the inductance (6) of the respectively associated phase module (1) from an intermediate setpoint value ($\Delta i_{U1}$) of the current ($i_{U1}$) through the phase module (1) is provided, and

in that each switching cell (2) has four drivable bidirectional power semiconductor switches with a controlled unidirectional current guidance direction, which power semiconductor switches are connected in the manner of a bridge circuit, and a capacitive energy storage means which is connected parallel to the bridge circuit of the power semiconductor switches, the phase module (1) additionally has at least one further two-pole switching cell (2), which is connected into the series connection, for switching at least one positive and at least one negative voltage between the poles, **characterized in that**, for all the phase modules (1), a common second calculation unit (5) for forming the intermediate setpoint value $\left(\Delta \vec{i_{U1}}\right)$ of the current ($i_{U1}$) through all the phase modules (1) from a sum $\left(\vec{U}sum1\right)$ of the voltages (UC1) across the capacitive energy storage means of the switching cells (3) of the phase modules (1), from a sum voltage setpoint value ($V_{ref, UC}$) and from the reference signal ($V_{ref, U1}$) in respect of the voltage (U1) across the phase modules in accordance with the formula $\Delta \vec{i}_{U1} = V_{\sigma=0} \cdot V_{\sigma=0}^{T} \cdot F \cdot \left(V_{ref,UC} - \vec{U}sum1\right) \cdot \vec{V}_{ref,U1}$

is provided, where F is a predefinable controller function, and where V is a predefinable decoupling matrix which serves to decouple circulating currents through the phase modules (1) from the currents ($i_u$) in the output phase connections (U2, V2, W2).

**Revendications**

1. Procédé de mise en fonctionnement d'un circuit inverseur, dans lequel le circuit inverseur comporte n branchements de phase d'entrée (U1, V1, W1) et p branchements de phase de sortie (U2, V2n, W2), où n≥2 et p≥2, et comprend (n·p) cellules de commutation bipolaires (2) pour la commutation d'au moins une tension positive et d'au moins une tension négative entre les pôles, dans lequel chaque branchement de phase de sortie (U2, V2, W2) est relié en série à chaque branchement de phase d'entrée (U1, V1, W1) respectivement au moyen d'une cellule de commutation (2), et chaque cellule de commutation (2) comporte des commutateurs à semi-conducteurs de puissance bidirectionnels commandés présentant un sens de guidage de courant unidirectionnel commandé et un accumulateur d'énergie capacitif,

dans lequel les commutateurs à semi-conducteurs de puissance des cellules de commutation (2) sont commandés au moyen d'un signal de commande (S1),

dans lequel, au moins une inductance (6) est insérée dans chaque liaison série du branchement de phase de sortie (U2, V2, W2) respectif à la cellule de commutation respective (2) et au branchement de phase d'entrée (U1, V1, W1) respectif, dans lequel une cellule de commutation (2) forme respectivement avec cette inductance (6) un composant de phase (1) et, pour chaque composant de phase (1), le signal de commande est établi à partir d'un signal de référence ($V_{ref, U1}$) par rapport à la tension (U1) aux bornes du composant de phase (1) et à partir d'un signal de tension ($V_L$) aux bornes de l'inductance (6) du composant de phase,

dans lequel le signal de tension ($V_L$) aux bornes de l'inductance (6) du composant de phase est établi à partir d'une valeur de consigne intermédiaire de courant ($\Delta i_{U1}$) du courant ($i_{U1}$) traversant le composant de phase (1), et

dans lequel chaque cellule de commutation (2) comporte quatre commutateurs à semi-conducteurs de puissance bidirectionnels actionnables reliés à la manière d'un circuit en pont présentant un sens de guidage de courant unidirectionnel commandé et un accumulateur d'énergie capacitif connecté en parallèle au circuit en pont des commutateurs à semi-conducteurs de puissance, le composant de phase (1) comporte en outre au moins une autre cellule de commutation (2) bipolaire insérée dans la liaison série pour la commutation d'au moins une tension positive et d'au moins une tension négative entre les pôles,

**caractérisé en ce que** la valeur de consigne intermédiaire de courant ($\Delta i_{U1}$) du courant ($i_{U1}$) traversant le composant de phase (1) est établie à partir d'une somme (Usum1) des tensions (UC1) aux bornes des accumulateurs d'énergie capacitifs des cellules de commutation (2) du composant de phase (1), à partir d'une valeur de consigne de tension de somme ($V_{ref,\,UC}$) et à partir du signal de référence ($V_{ref,\,U1}$) par rapport à la tension (U1) aux bornes du composant de phase conformément à la formule : $\Delta i_{U1} = F \cdot (V_{ref,UC} - Usum1) \cdot V_{ref,U1}$, où F est une fonction de régulation pouvant être prédéfinie.

2. Procédé de mise en fonctionnement d'un circuit inverseur, dans lequel le circuit inverseur comporte n branchements de phase d'entrée (U1, V1, W1) et p branchements de phase de sortie (U2, V2, W2), où $n \geq 2$ et $p \geq 2$, et comprend ($n \cdot p$) cellules de commutation bipolaires (2) pour la commutation d'au moins une tension positive et d'au moins une tension négative entre les pôles, dans lequel chaque branchement de phase de sortie (U2, V2, W2) est relié en série à chaque branchement de phase d'entrée (U1, V1, W1) respectivement au moyen d'une cellule de commutation (2), et chaque cellule de commutation (2) comporte des commutateurs à semi-conducteurs de puissance bidirectionnels actionnables présentant un sens de guidage de courant unidirectionnel commandé et un accumulateur d'énergie capacitif,

dans lequel les commutateurs à semi-conducteurs de puissance des cellules de commutation (2) sont commandés au moyen d'un signal de commande (S1),

dans lequel au moins une inductance (6) est insérée dans chaque liaison série du branchement de phase de sortie (U2, V2, W2) respectif à la cellule de commutation (2) correspondante et au branchement de phase d'entrée (U1, V1, W1) respectif, dans lequel une cellule de commutation (2) forme respectivement avec cette inductance (6) un composant de phase (1) et, pour chaque composant de phase (1), le signal de commande (S1) est établi à partir d'un signal de référence ($V_{ref,\,U1}$) par rapport à la tension (U1) aux bornes du composant de phase (1) et à partir d'un signal de tension ($V_L$) aux bornes de l'inductance (6) du composant de phase,

dans lequel chaque signal de tension ($V_L$) aux bornes de l'inductance (6) du composant de phase associé respectif est établi à partir de la somme respective des valeurs de consigne intermédiaires de courant ($\Delta i_{U1}$) du courant ($i_{U1}$) traversant le composant de phase (1) associé respectif, et

dans lequel chaque cellule de commutation (2) comporte quatre commutateurs à semi-conducteurs de puissance bidirectionnels actionnables reliés à la manière d'un circuit en pont présentant un sens de guidage de courant unidirectionnel commandé et un accumulateur d'énergie capacitif connecté en parallèle au circuit en pont des commutateurs à semi-conducteurs de puissance, le composant de phase (1) comporte en outre au moins une autre cellule de commutation (2) bipolaire insérée dans la liaison série pour commuter au moins une tension positive et au moins une tension négative entre les pôles,

**caractérisé en ce que** la valeur de consigne intermédiaire de courant ($\vec{\Delta i}_{U1}$) du courant ($i_{U1}$) traversant tous les composants de phase (1) est établi à partir d'une somme ($\vec{U}sum1$) des tensions (UC1) aux bornes des accumulateurs d'énergie capacitifs des cellules de commutation (3) des composants de phase (1), à partir d'une valeur de consigne de tension de somme ($V_{ref,\,UC}$) et à partir du signal de référence ($V_{ref,\,U1}$) par rapport aux tensions (U1) aux bornes des composants de phase conformément à la formule : $\vec{\Delta i}_{U1} = V_{\sigma=0} \cdot V_{\sigma=0}^{T} \cdot F \cdot ( V_{ref,UC} - \vec{U}sum1 ) \cdot \vec{V}_{ref,U1}$, où F est une fonction de régulation pouvant être prédéfinie et où V est une matrice de découplage pouvant être prédéfinie qui est utilisée pour le découplage des courants circulaires passant à travers les composants de phase (1) vis-à-vis des courants ($i_U$) passant dans les branchements de phase de sortie (U2, V2, W2).

3. Dispositif destiné à mettre en oeuvre un procédé de mise en fonctionnement d'un circuit inverseur, dans lequel le circuit inverseur comporte n branchements de phase d'entrée (U1, V1, W1) et p branchements de phase de sortie (U2, V2, W2), où $n \geq 2$ et $p \geq 2$, et comprend ($n \cdot p$) cellules de commutation bipolaires (2) pour la commutation d'au moins une tension positive et d'au moins une tension négative entre les pôles, dans lequel chaque branchement de phase de sortie (U2, V2, W2) est relié en série à chaque branchement de phase d'entrée (U1, V1, W1) respectivement au moyen d'une cellule de commutation (2), et chaque cellule de commutation (2) comporte des commutateurs à semi-conducteurs de puissance bidirectionnels actionnables présentant un sens de guidage de courant unidirectionnel commandé et un accumulateur d'énergie capacitif,

comportant un circuit de commande (3) servant à générer un signal de commande (S1), lequel circuit de commande (3) est relié aux commutateurs à semi-conducteurs de puissance de la cellule de commutation (2),

dans lequel au moins une inductance (6) est insérée dans chaque liaison série du branchement de phase de sortie (U2, V2, W2) respectif à la cellule de commutation (2) respective et au branchement de phase d'entrée (U1, V1, W1) respectif, dans lequel une cellule de commutation (2) forme respectivement avec cette inductance (6) un composant de phase (1), et la somme d'un signal de référence ($V_{ref, U1}$) par rapport à la tension (U1) aux bornes du composant de phase (1) et d'un signal de tension ($V_L$) aux bornes de l'inductance (6) du composant de phase est délivrée au circuit de commande (3) pour établir le signal de commande (S1), pour un composant de phase (1) respectif,

dans lequel, pour un composant de phase respectif (1), il est prévu une première unité de calcul (4) destinée à établir le signal de tension ($V_L$) aux bornes de l'inductance (6) du composant de phase à partir d'une valeur de consigne intermédiaire de courant ($\Delta i_{U1}$) du courant ($i_{U1}$) traversant le composant de phase (1), et dans lequel chaque cellule de commutation (2) comporte quatre commutateurs à semi-conducteurs de puissance bidirectionnels actionnables reliés à la manière d'un circuit en pont présentant un sens de guidage de courant unidirectionnel commandé et un accumulateur d'énergie capacitif connecté en parallèle au circuit en pont des commutateurs à semi-conducteurs de puissance, le composant de phase (1) comporte en outre au moins une autre cellule de commutation bipolaire (2) insérée dans la liaison série pour la commutation d'au moins une tension positive et d'au moins une tension négative entre les pôles,

**caractérisé en ce que**, pour chaque composant de phase (1), il est prévu une deuxième unité de calcul (5) destinée à déterminer la valeur de consigne intermédiaire de courant ($\Delta i_{U1}$) du courant ($i_{U1}$) traversant le composant de phase (1) à partir d'une somme (Usum1) des tensions (UC1) aux bornes des accumulateurs d'énergie capacitifs des cellules de commutation (2) du composant de phase (1), à partir d'une valeur de consigne de tension de somme ($V_{ref, UC}$) et à partir du signal de référence ($V_{ref, U1}$) par rapport à la tension (U1) aux bornes du composant de phase conformément à la formule : $\Delta i_{U1} = F \cdot (V_{ref,UC} - Usum1) \cdot V_{ref,U1}$, où F est une fonction de régulation pouvant être prédéfinie.

4. Dispositif destiné à mettre en oeuvre un procédé de mise en fonctionnement d'un circuit inverseur, dans lequel le circuit inverseur comporte n branchements de phase d'entrée (U1, V1, W1) et p branchements de phase de sortie (U2, V2, W2), où $n \geq 2$ et $p \geq 2$, et comprend $(n \cdot p)$ cellules de commutation bipolaires (2) pour la commutation d'au moins une tension positive et d'au moins une tension négative entre les pôles, dans lequel chaque branchement de phase de sortie (U2, V2, W2) est relié en série à chaque branchement de phase d'entrée (U1, V1, W1) respectivement au moyen d'une cellule de commutation (2), et chaque cellule de commutation (2) comporte des commutateurs à semi-conducteurs de puissance bidirectionnels actionnables présentant un sens de guidage de courant unidirectionnel commandé et un accumulateur d'énergie capacitif,

comportant un circuit de commande (3) servant à générer un signal de commande (S1), lequel circuit de commande (3) est relié aux commutateurs à semi-conducteurs de puissance de la cellule de commutation (2),

dans lequel au moins une inductance (6) est insérée dans chaque liaison série du branchement de phase de sortie (U2, V2, W2) respectif à la cellule de commutation (2) associée et au branchement de phase d'entrée (U1, V1, W1) respectif, dans lequel une cellule de commutation (2) forme respectivement avec cette inductance (6) un composant de phase (1), et la somme d'un signal de référence ($V_{ref, U1}$) par rapport à la tension (U1) aux bornes du composant de phase (1) et d'un signal de tension ($V_L$) aux bornes de l'inductance (6) du composant de phase est délivrée au circuit de commande (3) pour déterminer le signal de commande (S1), pour un composant de phase (1) respectif,

dans lequel, pour la totalité des composants de phase (1), il est prévu une première unité de calcul commune (4) destinée à établir le signal de tension ($V_L$) aux bornes de l'inductance (6) du composant de phase (1) associé respectif à partir d'une valeur de consigne intermédiaire de courant ($\Delta i_{U1}$) du courant ($i_{U1}$) traversant le composant de phase (1), et

chaque cellule de commutation (2) comporte quatre commutateurs à semi-conducteurs de puissance bidirectionnels actionnables reliés à la manière d'un circuit en pont présentant un sens de guidage de courant unidirectionnel commandé et un accumulateur d'énergie capacitif connecté en parallèle au circuit en pont des commutateurs à semi-conducteurs de puissance, le composant de phase (1) comporte en outre au moins une autre cellule de commutation (2) bipolaire insérée dans la liaison série pour la commutation d'au moins une tension positive et d'au moins une tension négative entre les pôles,

**caractérisé en ce que**, pour la totalité des composants de phase (1), il est prévu une deuxième unité de calcul (5) commune destinée à établir la valeur de consigne intermédiaire de courant ($\vec{\Delta i}_{U1}$) du courant ($i_{U1}$) traversant tous les composants de phase (1) à partir d'une somme ($\vec{U}sum1$) des tensions (UC1) aux bornes des accumulateurs d'énergie capacitifs des cellules de commutation (3) des composants de phase (1), à partir d'une valeur de consigne de tension de somme ($V_{ref, UC}$) et à partir du signal de référence ($V_{ref, U1}$) par rapport à la tension (U1) aux bornes des composants de phase, conformément à la formule : $\Delta \vec{i}_{U1} = V_{\sigma=0} \cdot V_{\sigma=0}^{T} \cdot F \cdot (V_{ref,UC} - \vec{U}sum1) \cdot \vec{V}_{ref,U1}$, où F est une fonction de régulation pouvant être prédéfinie et où V est une matrice de découplage pouvant être prédéfinie qui est utilisée pour le découplage des courants circulaires traversant les composants de phase (1) vis-à-vis des courants ($i_u$) passant dans les branchements de phase de sortie (U2, V2, W2).

$$\Delta \vec{i}_{U1} = V_{\sigma=0} \cdot V_{\sigma=0}^{T} \cdot F \cdot (V_{ref,UC} - \vec{U}sum1) \cdot \vec{V}_{ref,U1}$$

**Fig. 1**

**Fig. 2**

**Fig.3**

**Fig.4**

**Fig.5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6900998 B2
- WO 2008067788 A1
- WO 2007023064 A1
- WO 2008067784 A1

**In der Beschreibung aufgeführte Nicht-Patentliteratur**

- On Dynamics and Voltage Control of the Modular Multilevel Converter. *Power Electronics and Applications, 2009, EPE 2009, 13th European Conference on IEEE,* 18. September 2009
- **COLIN OATES.** A methodology for developing 'Chainlink' converters. *IEEE 13th European conference on power electronics and applications,* 2009, 1-10